(19) Europäisches Patentamt / European Patent Office / Office européen des brevets

(11) **EP 1 900 679 A1**

(12) **DEMANDE DE BREVET EUROPEEN**

(43) Date de publication:
**19.03.2008 Bulletin 2008/12**

(51) Int Cl.:
***B81B 3/00*** *(2006.01)* ***H01G 5/16*** *(2006.01)*

(21) Numéro de dépôt: **07116290.3**

(22) Date de dépôt: **13.09.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **15.09.2006 FR 0653779**

(71) Demandeur: **COMMISSARIAT A L'ENERGIE ATOMIQUE**
**75015 Paris (FR)**

(72) Inventeurs:
• **Casset, Fabrice**
**38570, TENCIN (FR)**
• **Soulimane, Sofian**
**38100, GRENOBLE (FR)**

(74) Mandataire: **Poulin, Gérard**
**BREVALEX**
**3, rue du Docteur Lancereaux**
**75008 Paris (FR)**

(54) **Mise en forme d'une couche sacrificielle pour realiser un element suspendu**

(57) L'invention concerne un procédé de réalisation d'une couche sacrificielle, comprenant les étapes de :
- lithographie d'une résine déposée sur un substrat pour fournir un motif de résine lithographiée sur une zone de substrat, la zone ayant une taille donnée et une forme donnée, le motif occupant un volume donné,
- recuit selon un cycle thermique du motif de résine lithographiée,

le procédé étant caractérisé en ce qu'il comprend, en fonction de la résine, la détermination de la taille et de la forme de ladite zone du substrat, et la détermination du volume de la résine déposée sur ladite zone pour que le cycle thermique de recuit fournisse un profil choisi parmi l'un des profils suivants : un profil bombé planarisant et un profil en « double air gap ».

EP 1 900 679 A1

**Description**

**DOMAINE TECHNIQUE**

L'invention se rapporte à un procédé de mise en forme d'une couche sacrificielle pour réaliser un élément suspendu (poutre ou membrane) notamment dans un MEMS. Elle peut s'appliquer également aux autres domaines de l'électronique et de la microélectronique qui utilisent des condensateurs variables, des commutateurs et des résonateurs.

**ÉTAT DE LA TECHNIQUE ANTÉRIEURE**

Le développement d'appareils portables de plus en plus petits et performants incite à rechercher des nouveaux composants pour réaliser de nouvelles fonctionnalités. Dans les applications radiofréquences, les micro-systèmes électromécaniques (MEMS) sont des alternatives crédibles aux composants « classiques » de la microélectronique de par leur intégration et leurs performances théoriques.

Le principe de fonctionnement des MEMS est basé sur le mouvement mécanique d'une membrane ou d'une poutre suspendue au-dessus d'un substrat. Pour cela, le développement de MEMS nécessite souvent l'utilisation d'une couche sacrificielle permettant de suspendre un élément (poutre ou membrane) afin qu'il soit mobile ou isolé du substrat.

Comme les circuits intégrés en microélectronique, ces dispositifs sont fabriqués par empilement de différentes couches minces de matériaux différents. Par ailleurs, afin de définir une géométrie particulière, ces matériaux peuvent être recuits, polis, gravés partiellement (en utilisant la photolithographie) ou complètement comme c'est le cas de la couche sacrificielle.

Un composant MEMS peut comprendre une cavité et des électrodes discontinues créant une topologie en surface du substrat. Mais cela reste un exemple car on peut avoir une membrane sans cavité comme c'est le cas pour l'encapsulation ou avec une électrode continue comme pour les résonateurs ...

La réalisation d'un MEMS doit prendre en compte les exigences du cahier des charges. Ces exigences comprennent par exemple, dans le cas d'une membrane : le tension d'actionnement et/ou l'amplitude de mouvement de la membrane, la fréquence de résonance, les propriétés mécaniques de la membrane, ...

A partir de ce cahier des charges, un calcul dimensionnel de la membrane en fonction du matériau constitutif choisi est effectué. On utilise des logiciels de calcul par éléments finis (ANSYS, COVENTOR, ...) et/ou les formules analytiques de la mécanique des poutres (voir le document [1] placé en fin de description). On en tire la longueur L de la membrane, sa largeur l, son épaisseur e, sa rigidité k et l'entrefer (donc la distance entre les électrodes d'un commutateur) d.

Ce dimensionnement renseigne sur le besoin ou non d'avoir une cavité sous la membrane. En effet, selon le matériau choisi pour le membrane (nitrure/or, or, Al, AlSi, Si, polySi, oxyde, ...) et sa contrainte intrinsèque qui va induire un déplacement de la membrane lors de la gravure de la couche sacrificielle, on peut prévoir l'entrefer restant. Selon l'entrefer envisagé, il peut être nécessaire de prévoir une cavité dont on déterminera la profondeur.

Cette cavité aura environ pour longueur L. Sa profondeur sera fonction de d.

Ensuite, on peut choisir la couche sacrificielle à utiliser et son épaisseur (fonction de la profondeur de cavité, de d et devant être compatible avec le matériau de membrane (le profil de la couche sacrificielle doit résister à la température de dépôt de la membrane et elle doit pouvoir se graver facilement). Le procédé de réalisation est défini en concordance avec les matériaux de la couche sacrificielle et de la membrane.

Le procédé de réalisation comprend des étapes de dépôt, de photolithographie et de gravure, de mise en forme de la couche sacrificielle, de réalisation de la membrane et de gravure de la couche sacrificielle.

Le matériau recherché pour la réalisation de la couche sacrificielle doit répondre aux caractéristiques suivantes : être stable thermiquement afin de supporter le budget thermique des étapes ultérieures, être facile à mettre en oeuvre, pouvoir planariser la topologie de la surface sur laquelle il est déposé, ne pas laisser de résidus lors de son élimination.

On peut distinguer trois types de couches sacrificielles connues de l'homme de l'art : des substances organiques du type polymères photosensibles, des substances organiques du type polymères non-photosensibles comme le polyimide, des substances non organiques comme l'oxyde de silicium, le chrome, le cuivre, le tungstène.

Le contrôle de la distance séparant une électrode (disposée sur un élément suspendu) du substrat en regard, et pourvue d'une autre électrode, est un point important du bon fonctionnement d'un MEMS. Il nécessite une maîtrise très rigoureuse de la couche sacrificielle qui doit présenter le minimum de topologie avec un profil contrôlée et une haute stabilité thermique supérieure à la température de dépôt de la membrane ou de la micropoutre.

Les polymères non photosensibles sont difficiles à mettre en oeuvre et nécessitent l'utilisation d'un autre matériau au-dessus d'eux qui soit photosensible ou qui reproduise les motifs à graver, afin d'être gravé. Les matériaux non organiques sont bien contrôlés en épaisseur, mais par contre ils reproduisent la topologie sur laquelle ils sont déposés. Pour avoir une couche sacrificielle non organique plane, il faut passer par une étape de polissage (CMP) coûteuse. De plus, les polymères non photosensibles et les matériaux non organiques nécessitent des techniques de gravure appropriées et sont généralement plus durs à manipuler et à enlever lors de la libération, laissant des résidus.

Les polymères photosensibles utilisés dans l'art connu sont également peu planarisants. Ainsi, la topologie sous la couche sacrificielle sera répliquée sur la membrane réalisée au-dessus. Le document [2], placé en fin de description, divulgue un essai de planarisation d'une couche sacrificielle en polymère multicouche. Le profil obtenu présente un creux qui peut être problématique dans certains cas (membrane en compression).

Les couches sacrificielles permettent de réaliser une variété de composants : les condensateurs variables, les micro-commutateurs, les résonateurs ou filtres micromécaniques qui opèrent sur les modes de résonance mécanique de systèmes micrométriques, les dispositifs FBAR (pour « Film Bulk Acoustic Resonator »), les capteurs tels que les accéléromètres, les gyromètres, ...

On va approfondir l'exemple du condensateur variable. La capacité est définie entre deux électrodes en regard par l'expression suivante : $C = \dfrac{\varepsilon S}{d}$ , C étant la valeur de capacité du condensateur, ε la valeur de la permittivité du milieu entre les électrodes, S la surface en regard et d la distance entre les électrodes.

Pour faire varier la capacité du condensateur, il existe trois moyens connus : la variation de la distance entre les électrodes (condensateur à variation d'entrefer), la variation de la surface d'électrodes en regard (condensateur à variation de surface) et la variation de la permittivité entre les électrodes.

Le composant le plus avantageux est le condensateur variable électrostatique à variation d'entrefer. Mais il présente le problème dit de « pull-in » (collage des électrodes au 1/3 de l'entrefer). Pour éviter ce problème, on peut envisager un « double air gap ». Le principe de la structure à « double air gap » a été présenté dans les documents [3] et [4] cités en fin de description. Cette structure comporte des électrodes d'actionnement formant un condensateur dont l'entrefer est plus grand que celui du condensateur variable, de manière à éviter le phénomène de « pull-in ».

Les condensateurs variables « double air gap » de l'art connu nécessitent une multiplication des étapes de dépôt - photolithographie - gravure afin d'obtenir le « double air gap » ainsi qu'une étape de polissage coûteuse par CMP afin de planariser la couche sacrificielle.

## EXPOSÉ DE L'INVENTION

La présente invention a été conçue afin de mettre en forme la couche sacrificielle tout en simplifiant son procédé de réalisation. Elle permet de planariser une couche sacrificielle. Elle permet aussi de réaliser à moindre coût un condensateur variable à « double air gap ».

L'invention a pour objet un procédé de réalisation d'une couche sacrificielle, comprenant les étapes de :

-   lithographie d'une résine déposée sur un substrat pour fournir un motif de résine lithographiée sur une zone de substrat, la zone ayant une taille donnée et une forme donnée, le motif occupant un volume donné,
-   recuit selon un cycle thermique du motif de résine lithographiée,

le procédé étant caractérisé en ce qu'il comprend, en fonction de la résine, la détermination de la taille et de la forme de ladite zone du substrat, et la détermination du volume de la résine déposée sur ladite zone pour que le cycle thermique de recuit fournisse un profil choisi parmi l'un des profils suivants : un profil bombé planarisant et un profil en « double air gap », dans lequel, la couche sacrificielle étant destinée à servir de support de formation d'un élément suspendu, la détermination de la taille et de la forme de ladite zone et la détermination du volume de la résine déposée sur ladite zone sont obtenues par la délimitation d'une gamme de fréquence de résonance pour l'élément suspendu, ce qui définit l'intervalle devant séparer l'élément suspendu de ladite zone de substrat, la résine étant alors choisie pour procurer un motif capable de fournir ledit intervalle.

La résine peut être une résine polymère photosensible.

La zone du substrat peut être constituée par le fond d'une cavité réalisée dans le substrat.

Selon une première variante de mise en oeuvre, ladite zone du substrat présentant une topologie de surface, les étapes de lithographie et de recuit sont réalisées en plusieurs fois, le procédé comprenant :

-   une première étape de lithographie effectuée à partir d'une première couche de résine fournissant un premier élément de motif au moyen d'un masque,
-   une première étape de recuit du premier élément de motif,
-   une étape d'amincissement du premier élément de motif pour minimiser la topologie de surface de ladite zone reproduite à la surface du premier élément de motif,
-   une deuxième étape de lithographie effectuée à partir d'une deuxième couche de résine déposée sur le substrat, fournissant, au moyen dudit masque, un deuxième élément de motif superposé au premier élément de motif aminci pour constituer ledit motif,

- une deuxième étape de recuit appliquée au motif obtenu, la première étape de recuit et la deuxième étape de recuit fournissant au motif obtenu un profil bombé planarisant.

Selon une deuxième variante de mise en oeuvre, ladite zone du substrat présentant une topologie de surface, les étapes de lithographie et de recuit sont réalisées en plusieurs fois, le procédé comprenant :

- une première étape de lithographie effectuée à partir d'une première couche de résine fournissant un premier élément de motif au moyen d'un masque,
- une première étape de recuit du premier élément de motif,
- une étape d'amincissement du premier élément de motif pour minimiser la topologie de surface de ladite zone reproduite à la surface du premier élément de motif,
- une deuxième étape de lithographie effectuée à partir d'une deuxième couche de résine déposée sur le substrat, fournissant, au moyen dudit masque, un deuxième élément de motif superposé au premier élément de motif aminci,
- une deuxième étape de recuit appliquée à la superposition du premier élément de motif et du deuxième élément de motif, provoquant l'apparition de deux pics sur ladite superposition, constituant un profil en « double air gap »,
- une troisième étape de lithographie effectuée à partir d'une troisième couche de résine déposée sur le substrat, fournissant, au moyen dudit masque, un troisième élément de motif superposé au premier élément de motif et au deuxième élément de motif aminci,
- une troisième étape de recuit appliquée à la superposition d'éléments de motif obtenu pour conférer au motif obtenu le profil final en « double air gap ».

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 est un organigramme détaillant les paramètres influant sur le profil final de la couche sacrificielle,
- les figures 2A à 2C sont des diagrammes montrant l'influence des rampes de température sur le profil final d'un motif de couche sacrificielle,
- les figures 3A et 3B sont des diagrammes montrant l'influence de la largeur des motifs sur le profil de la couche sacrificielle,
- la figure 4 est un diagramme montrant un profil de couche sacrificielle mince,
- la figure 5A est une vue de dessus d'une partie d'un substrat recouvert de pistes électriquement conductrices et la figure 5B est un diagramme représentant le profil d'une couche sacrificielle réalisée sur cette partie de substrat,
- la figure 6 représente un organigramme décrivant l'influence de paramètres sur le profil de la couche sacrificielle,
- les figures 7A à 7C sont des diagrammes représentant des profils d'une couche sacrificielle,
- les figures 8A à 8I illustrent un procédé de réalisation d'un condensateur variable à « double air gap », conformément à l'invention,
- les figures 9 et 10 sont d'autres diagrammes représentant des profils de couches sacrificielles.

## EXPOSÉ DÉTAILLÉ DE MODES DE RÉALISATION PARTICULIERS

Plusieurs paramètres peuvent influencer l'aspect final de la couche sacrificielle, en particulier la manière de déposer la résine polymère photosensible, la nature du polymère, sa viscosité, sa capacité d'adhésion, le traitement thermique subséquent au dépôt, les solvants utilisés lors de la dilution, les conditions atmosphériques (température et humidité) et les conditions de stockage.

Pour comprendre l'évolution de ces paramètres, il faut connaître les séquences de mise en oeuvre de cette couche sacrificielle. Le procédé de réalisation d'un élément suspendu comprend des étapes de dépôt de résine, de recuit (par exemple vers 90°C) pour donner une tenue à la résine, d'insolation de la résine, de révélation ou développement de la résine, de cycle thermique qui se poursuit par le dépôt de l'élément suspendu et la gravure d'ouvertures pour obtenir l'accès à la couche sacrificielle et son élimination.

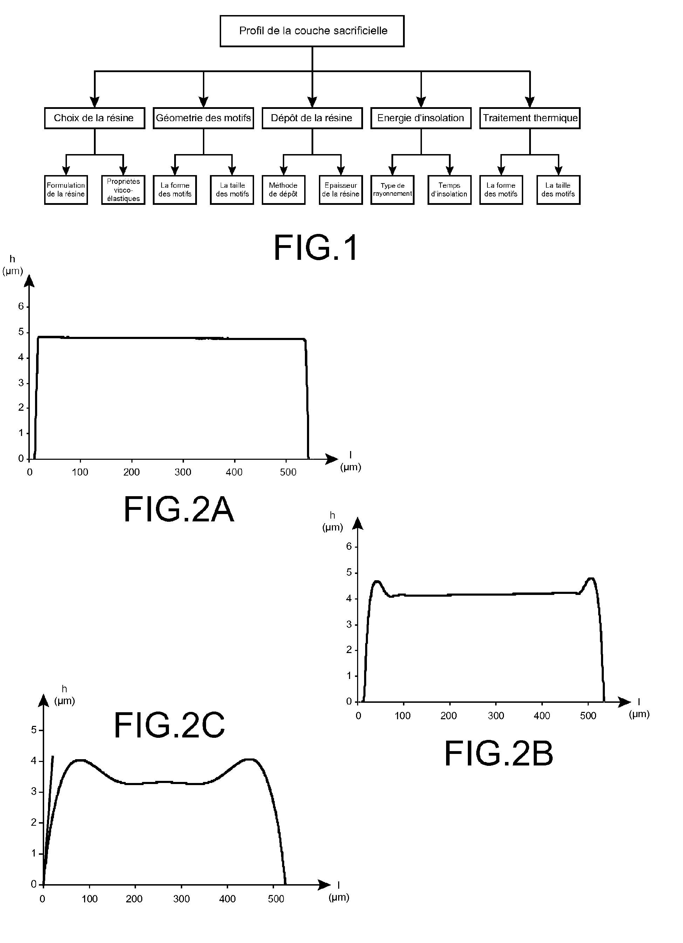

L'optimisation du profil de la couche sacrificielle correspond à l'optimisation de chaque étape de la séquence de réalisation. Les premières étapes sont considérées comme standard en lithographie. L'invention va s'appuyer essentiellement sur le traitement thermique et la manière dont le profil varie en fonction des contraintes géométriques en surface (taille et forme des motifs) et en volume (cavités lignes d'électrodes inférieures...). La figure 1 est un organigramme qui détaille les paramètres qui influent sur le profil final de la couche sacrificielle, c'est-à-dire le choix de la résine (sa formulation et ses propriétés viscoélastiques), la géométrie des motifs (leur forme et leur taille), le dépôt de la résine (sa méthode de dépôt et son épaisseur), l'énergie d'insolation (le type de rayonnement et le temps d'insolation), le traitement thermique appliqué (par rapport à la forme et la taille des motifs).

Le dépôt de résine est de préférence effectué grâce à une tournette, l'électrodéposition nécessitant une surface entièrement conductrice. L'effet du rayonnement sur les résines est régi par leurs domaines d'absorption. Cela conditionne les chimistes de formuler des résines qui sont sensibles aux UV proches ou profonds. Le contrôle du rayonnement est régi par le temps d'insolation et la dose d'énergie d'exposition. Par conséquent, le choix de résine conditionne non seulement l'intervalle d'exposition mais aussi les propriétés viscoélastiques de la matrice en fonction de la température qui se répercutent sur le comportement en fonction de la température, de la topologie de surfaces et de la géométrie des motifs.

Selon l'invention, on met en oeuvre un procédé d'impression avec des résines formulées pour obtenir des motifs à flancs droits après lithographie. L'utilisation de celles-ci comme couches sacrificielles implique un procédé particulier afin d'obtenir un passage de marche à pente faible (pour assurer la continuité du dépôt).

Généralement une résine photosensible est une formulation de solution de photopolymère qui devient sensible au rayonnement après séchage. Cette formulation permet un dépôt dans un état liquide sur un métal ou sur d'autres substrats avec une étape de séchage préliminaire à l'insolation. Une résine est un composé organique, généralement comprenant un polymère thermoplastique, dont la solubilité est affectée par le rayonnement UV. Il existe deux types de résines :

- les résines négatives : le rayonnement UV entraîne une polymérisation des zones exposées, conférant ainsi à ces zones une tenue particulière au solvant de révélation alors que les parties non insolées disparaissent sélectivement dans ce solvant.
- Les résines positives : le rayonnement UV entraîne une rupture des macromolécules, d'où la solubilité accrue des zones exposées dans le révélateur.

Les propriétés de la résine sont guidées par des modifications photochimiques du matériau photo-actif, ce qui a pour conséquence le changement d'un point de vue solubilité avec des vitesses de dissolution du film variant d'un facteur 100. Plusieurs résines de fournisseurs différents ont été utilisées : la résine positive JSR 335 disponible chez JSR Corporation, la résine positive Series S1800 disponible chez Rhom and Haas (Shipley), la résine positive MAP 1275 disponible chez Microresist Technology et la résine négative SC Resist disponible chez Arch Chemicals.

L'étape du traitement thermique a pour objectif de durcir la résine, d'améliorer l'adhésion et d'éliminer tous les résidus du solvant. Cette étape prépare aussi la résine à suivre une subséquente étape dans le procédé (dépôt de la membrane). L'effet de cette étape agit directement sur l'évaporation des petites molécules. Ce phénomène permet d'augmenter la température de transition vitreuse «Tg» et par conséquent augmenter la stabilité thermique du film car cette température est considérée comme la limite de stabilité du profil final de la couche sacrificielle.

Pour évaluer l'effet de la température, des mesures au profilomètre à différents stades du traitement thermique ont réalisées. Les figures 2A à 2C sont des diagrammes montrant l'influence des rampes de température sur le profil final d'un motif de couche sacrificielle. L'axe des abscisses représente la largeur 1 du profil et l'axe des ordonnées représente la hauteur h de la couche. La figure 2A montre le profil final de la couche sacrificielle après une deuxième insolation à 90°C de recuit (pente des bords de la couche sacrificielle 80°). La figure 2C montre le profil final de la même couche sacrificielle après une deuxième insolation à 120 °C de recuit (pente des bords de la couche sacrificielle 50°). La figure 3C montre le profil final de la même couche sacrificielle après une deuxième insolation à 200°C de recuit (pente des bords de la couche sacrificielle 10°).

Les figures 2A à 2C montrent bien l'apparition, entre 90°C et 120°C de recuit, de pics qui vont croître jusqu'à une limite qui dépend de l'épaisseur de la couche, de la présence ou non d'une cavité où est disposé le motif de la couche sacrificielle, de la viscosité et de la formulation de la résine...

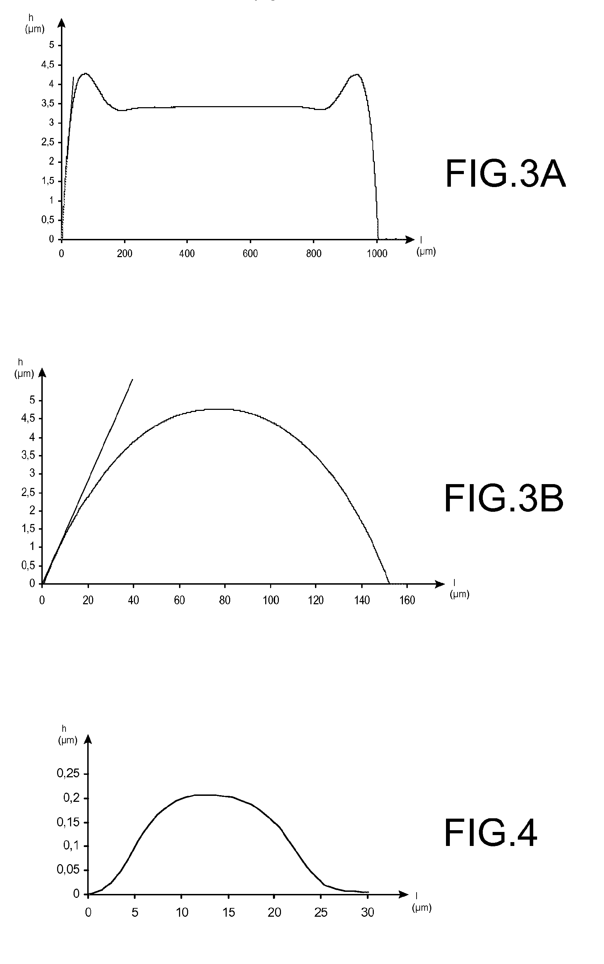

On voit bien que la naissance de ces pics est un réarrangement moléculaire des composants de la résine grâce à l'énergie thermique apportée. Les profils finals après le traitement thermique montrent que la position des pics est de plus en plus rapprochée en augmentant l'épaisseur de la couche sacrificielle, ce qui signifie que pour chaque épaisseur de la couche sacrificielle (qui dépend de la résine et de sa viscosité) il existe une limite de largeur de motif qui permet de passer d'un profil à deux pics à un profil bombé planarisant comme le montrent les figures 3A et 3B.

Les figures 3A et 3B sont des diagrammes, fournis par un profilomètre, montrant l'influence de la largeur des motifs, sur lesquels sont réalisées des couches sacrificielles, sur le profil de la couche sacrificielle. L'axe des abscisses représente la largeur l du profil et l'axe des ordonnées représente la hauteur h de la couche. Pour ces figures, la résine utilisée est la résine JSR 335 et la hauteur visée de couche sacrificielle est 4,5 $\mu$m. La figure 3A montre le profil obtenu pour un grand motif (1000 $\mu$m de largeur) après un recuit à 300°C (pente des bords de la couche sacrificielle 6°). La figure 3B montre le profil obtenu pour un petit motif (145 $\mu$m de largeur) après un recuit à 300°C (pente des bords de la couche sacrificielle 9°).

Les petits motifs présentent le profil planarisant avec un effet bombé ce qui constitue un résultat important pour les résonateurs MEMS ou d'autres composants de petites dimensions. Ainsi, la figure 4 montre le profil final d'une couche sacrificielle mince (hauteur environ 200 nm).

Le profil bombé montré sur les figures 3B et 4 est considéré comme l'effet planar désiré, vu la pente des bords de la couche sacrificielle qui est inférieure à 10° et le rapport entre la largeur du motif et l'épaisseur de la couche sacrificielle qui est supérieur à 10.

Si les motifs sur lesquels sont produites les couches sacrificielles se situent dans des cavités formées à partir d'une face d'un substrat, on observe le même type de profil que précédemment mais la position des pics a tendance à se diriger vers le centre. Ce résultat conforte la non apparition des pics pour des petits motifs. Le fait d'avoir une surface de motif avec des électrodes inférieures (pistes de contact), qui constituent une topologie par-dessus la surface, donne un nouveau problème de topologie qui est reproduit par la couche sacrificielle.

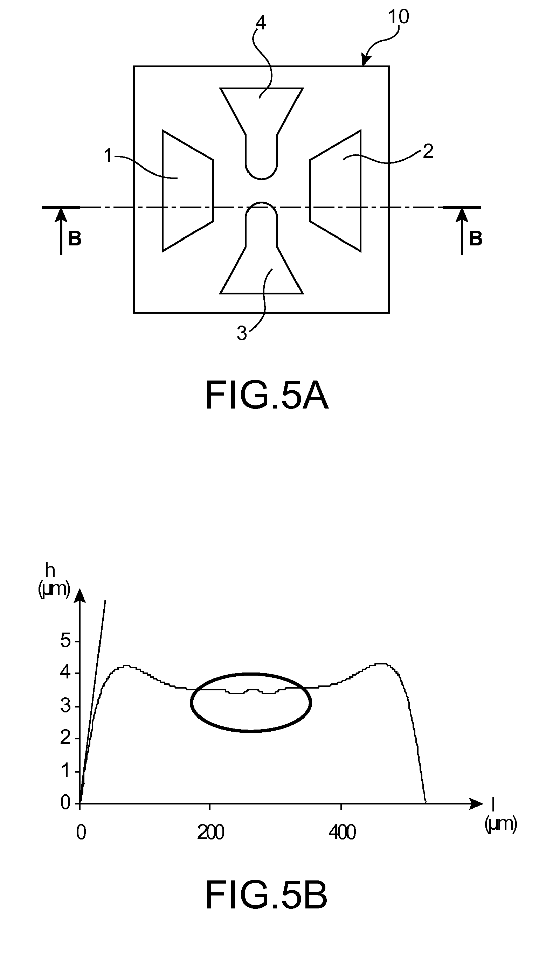

Les figures 5A et 5B illustrent cet effet de topologie de surface reproduite à la surface de la couche sacrificielle. La figure 5A est une vue de dessus d'une partie 10 d'un substrat recouvert de pistes électriquement conductrices 1, 2, 3 et 4. La figure 5B est un diagramme représentant le profil d'une couche sacrificielle réalisée sur la partie 10 du substrat. L'axe des abscisses représente la largeur l de la couche sacrificielle et l'axe des ordonnées représente sa hauteur h. Le profil montré sur le diagramme correspond à l'axe BB sur la figure 5A. La partie du profil entourée par la courbe 5 sur la figure 5B est la topologie des électrodes 1, 2 et 3 reproduite en surface de la couche sacrificielle.

Pour remédier à ce problème, on utilise, selon l'invention, une bicouche sacrificielle et on procède, après le traitement thermique appliqué à la première couche sacrificielle déposée, à un amincissement de cette première couche. L'utilisation d'un multicouche permet non seulement de planariser la couche sacrificielle, mais aussi de jouer sur la surépaisseur des pics par rapport au centre des grands motifs en variant la profondeur de la cavité, la largeur et la longueur des motifs. Cela permet d'atteindre un profil « double air-gap » qui peut être utilisé pour des condensateurs variables.

Pour résumer, voici l'influence des paramètres les plus importants sur le profil final de la couche sacrificielle :

- pour un substrat sans piste et sans cavité : apparition de pics pour les grands motifs,
- présence d'une cavité : les pics se rapprochent du centre du motif,
- présence de pistes sur le substrat : les pics s'éloignent vers l'extérieur du motif, la topologie des pistes est reproduite en surface,
- application d'un cycle thermique sous atmosphère inerte : les pics se rapprochent du centre du motif,
- augmentation de la viscosité de la résine : les pics se rapprochent du centre du motif,
- augmentation de l'épaisseur de la résine: les pics se rapprochent du centre du motif,
- couche sacrificielle en multicouche : permet de gérer l'entrefer « double air gap ».

Le choix de la résine polymère est conditionné par la température de dépôt de l'élément suspendu (poutre ou membrane). L'utilisation d'une résine photosensible comme couche sacrificielle juste après l'étape de lithographie n'est pas possible. En effet, la couche de résine lithographiée ne peut résister à des températures de dépôt de l'élément suspendu supérieures à 100°C puisque la température de transition vitreuse de la résine est très basse. D'autre part, le profil de cette couche n'est pas bien adapté à ce type d'application car la pente est trop raide (70° à 90°). Le traitement thermique constitue une excellente alternative pour non seulement aboutir au profil recherché (selon l'application) mais aussi pour augmenter la résistance thermique du profil de la couche sacrificielle lors du dépôt de l'élément suspendu (poutre, membrane). Les modifications de la composition chimique (additifs solvants, polarité..) et des propriétés viscoélastiques (masse moléculaire, conformation des chaînes macromoléculaires,...) de la couche sacrificielle qui en résultent conduisent a une meilleure stabilité tri-dimensionnelle du profil final après le traitement thermique. Les techniques de traitement thermique sont variées. Elles consistent en une succession de chauffages et de refroidissements, dont les cycles et les températures sont contrôlés avec précision. Pour la présente invention, le recuit se pratique avec une vitesse de chauffage suffisamment lente, pour une meilleure organisation des chaînes moléculaires et l'évaporation des petites molécules. Un refroidissement lent est nécessaire pour éviter un choc thermique qui serait néfaste au profil de la couche sacrificielle. Apres ce cycle, le profil final est stable jusqu'à la température de transition vitreuse Tg de la couche sacrificielle. En fixant les paramètres géométriques des composants et le matériau de l'élément suspendu (température de dépôt), le concepteur peut s'appuyer sur les propriétés thermiques des résines et la limite de profil entre les petits et grands motifs, pour choisir la couche qui aura la plus haute température de transition vitreuse après le cycle thermique avec le profil recherché. L'optimisation du traitement thermique nécessite en général des mesures de profils avec différents cycles thermiques pour atteindre la meilleure résistance aux dégradations.

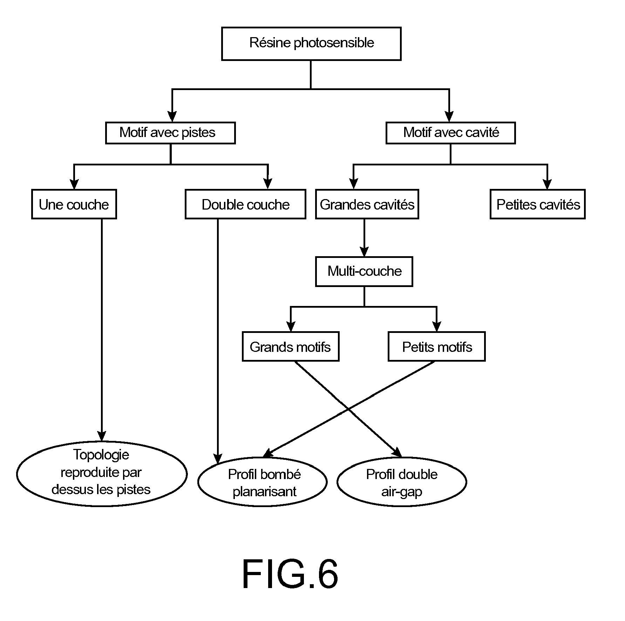

La figure 6 est un organigramme décrivant l'influence des paramètres géométriques et de la mise en oeuvre des étapes du procédé sur le profil de la couche sacrificielle, sachant que l'épaisseur de la couche sacrificielle donne la limite entre petit et grand motif.

Le traitement de la couche sacrificielle selon l'invention permet l'obtention de profils adéquats pour tous les microsystèmes, capteurs ou MEMS. On peut ainsi traiter la couche sacrificielle pour la planariser afin d'obtenir des micro-commutateurs performants.

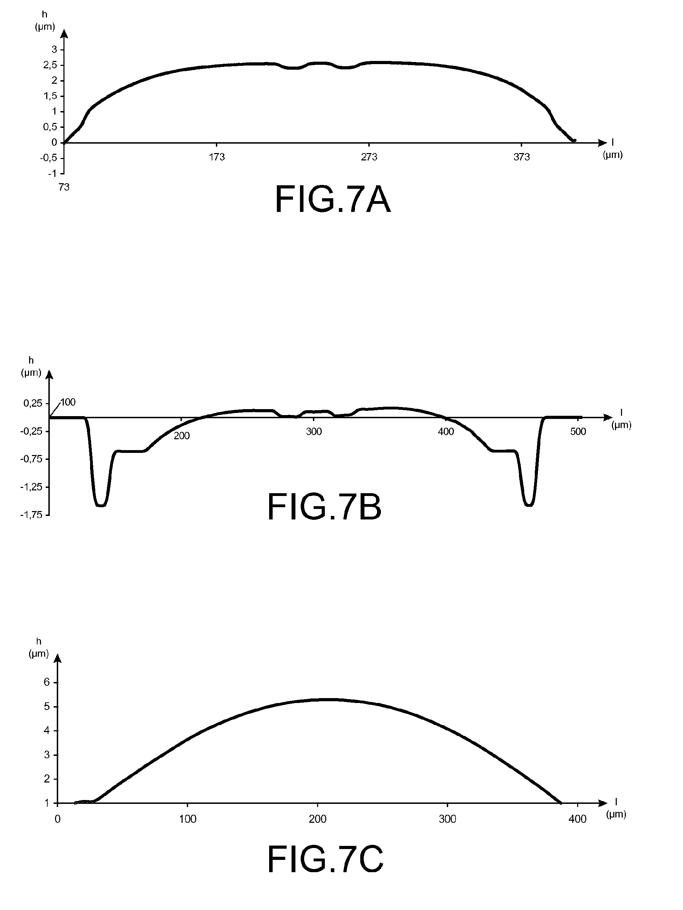

Les figures 7A à 7C sont des diagrammes montrant des profils relatifs à une couche sacrificielle déposée sur une face d'un substrat et traitée selon l'invention. La figure 7A montre le profil d'une première couche sacrificielle déposée sur le motif d'un substrat comportant des pistes électriques. La figure 7B montre l'amincissement de la première couche sacrificielle, réalisé par gravure, pour minimiser voire éliminer la topologie reproduite. La figure 7C montre le profil de la couche sacrificielle obtenue après le dépôt d'une deuxième couche sacrificielle planarisante.

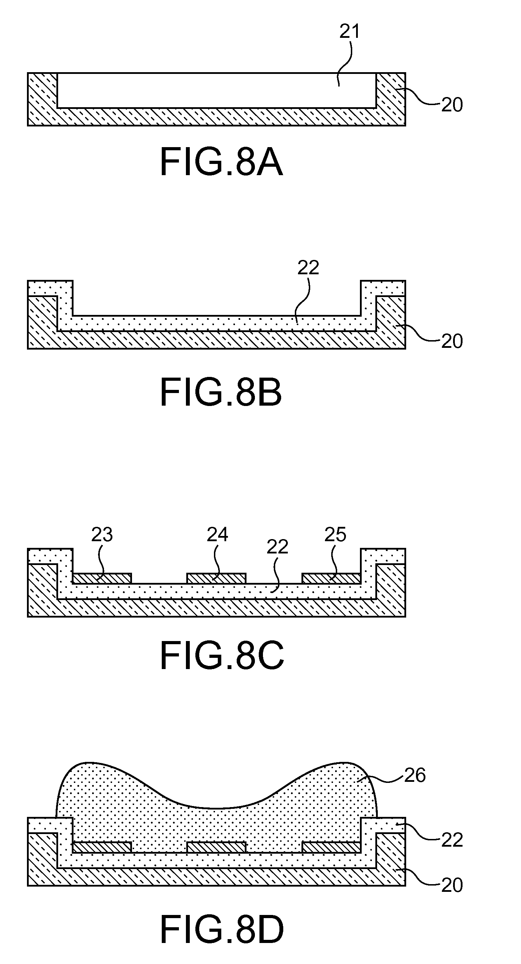

Les figures 8A à 8I illustrent un procédé de réalisation d'un condensateur variable à « double air gap » en mettant en forme une couche sacrificielle, conformément à l'invention. Ce sont des vues en coupe selon l'un des axes de la cavité.

La figure 8A montre un substrat en silicium 20 pourvu d'une cavité 21 gravée à partir de l'une de ses faces principales. La profondeur de la cavité est supérieure à 4 $\mu$m.

On procède alors à une oxydation thermique de la face du substrat comportant la cavité 21 pour obtenir une couche d'oxyde de silicium 22 de 1 $\mu$m d'épaisseur (voir la figure 8B).

L'étape suivante consiste à déposer des électrodes 23, 24 et 25 (électrodes inférieures) sur la couche d'oxyde 22 recouvrant le fond de la cavité 21. Ces électrodes sont constituées par le dépôt de couches de Ti/Au ou de Cr/Au ou de Pt. L'épaisseur de ces électrodes est comprise entre 0,02 $\mu$m et 0,8 $\mu$m (voir la figure 8C).

Ensuite, une couche sacrificielle tricouche 26 est déposée dans la cavité et déborde de cette cavité (voir la figure 8D). La résine photosensible est déposée de la manière suivante. Une première couche de résine de 2,5 $\mu$m d'épaisseur est mise en forme dans la cavité (ou les cavités d'un même substrat pour une fabrication collective). Un traitement thermique de recuit jusqu'à 350°C, avec une pente de 5°C/min, est appliqué à la résine. Après ce recuit, la couche de polymère obtenue est amincie de 1 $\mu$m par gravure au moyen d'un plasma d'oxygène sous une puissance choisie en fonction de la vitesse de gravure désirée, par exemple une puissance de 100 W. Ceci permet de minimiser, voire éliminer, la topologie reproduite par les électrodes inférieures. En utilisant le même masque, une deuxième couche plus épaisse de résine (environ 4,5 $\mu$m) est déposée. Le même traitement thermique provoque l'apparition de deux pics aux bords des cavités sans les remplir. On procède alors à un amincissement pour amorcer le dépôt de la troisième couche et enlever les reliefs créés en dehors de la cavité (ou des cavités). Toujours en utilisant le même traitement thermique, une troisième couche de 4 $\mu$m d'épaisseur donne l'allure finale du « double air gap ». La résine utilisée est par exemple une résine polymère novolac très couramment utilisée en microélectronique.

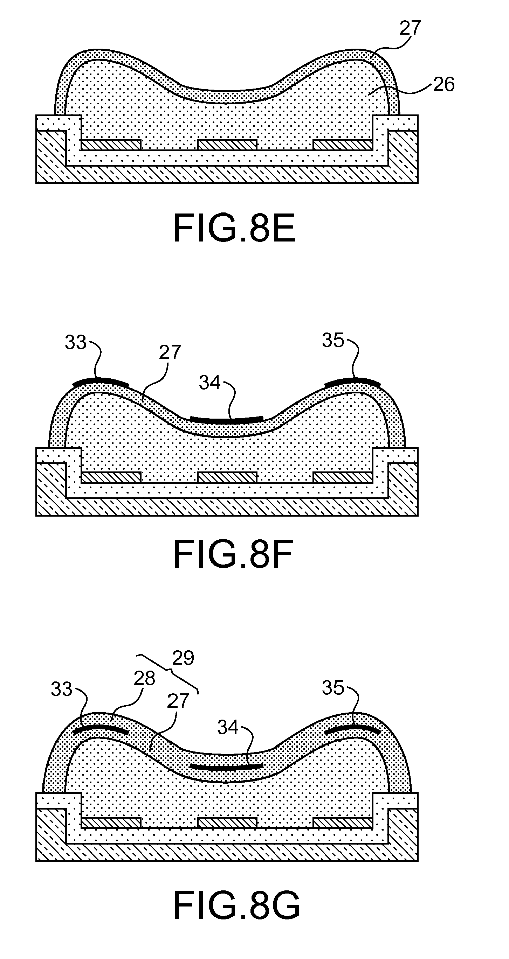

L'étape suivante consiste à déposer une première couche 27 de matériau diélectrique sur la couche sacrificielle 26. La couche 27 peut avoir une épaisseur de 0,4 $\mu$m (voir la figure 8E).

On dépose ensuite, par une méthode bien connue de l'homme de l'art, des électrodes 33, 34 et 35 (électrodes supérieures) sur la couche diélectrique 27 et en vis-à-vis des électrodes inférieures 23, 24 et 25. Ces électrodes sont constituées par le dépôt de couches de Ti/Au ou de Cr/Au ou de Pt. L'épaisseur de ces électrodes est comprise entre 0,02 $\mu$m et 0,8 $\mu$m (voir la figure 8F).

Une deuxième couche 28 de matériau diélectrique est déposée sur la structure obtenue comme le montre la figure 8G. La couche 28 englobe les électrodes supérieures 33, 34 et 35. Son épaisseur est calculée, en fonction de l'épaisseur de la première couche diélectrique 27, pour fournir l'épaisseur désirée de l'élément suspendu 29 (poutre ou membrane).

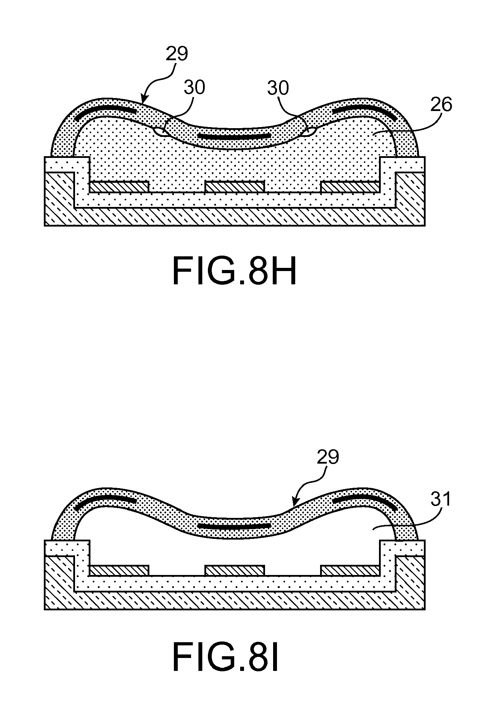

Des ouvertures 30 sont ensuite pratiquées pour accéder à la couche sacrificielle 26 (voir la figure 8H).

La dernière étape consiste à libérer l'élément suspendu 29 par gravure de la couche sacrificielle. Cette libération est obtenue grâce à un plasma piégé dans une chambre, ce qui lui permet d'agir de manière isotrope (procédé « downstream »). Le plasma est choisi en fonction de la sélectivité de gravure entre le matériau de l'élément suspendu et le matériau de la couche sacrificielle. Le plasma peut être un plasma de $N_2O_2$ ou un plasma de $CHF_4$. Les paramètres de gravure de la couche sacrificielle sont par exemple : température 250°C, pression 1100 mTorr, puissance micro-onde 2700 W, durée 180 secondes pour un plasma de $N_2O_2$.

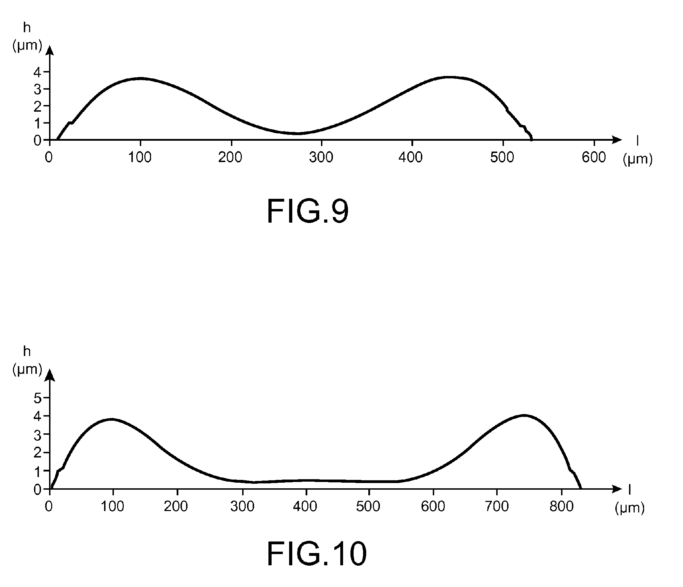

A titre complémentaire, les figures 9 et 10 sont des diagrammes représentant des profils de couches sacrificielles polymères, formées dans les deux cas de trois couches. La couche sacrificielle de la figure 9 est obtenue pour un motif dont les dimensions des cavités sont 500 $\mu$m x 500 $\mu$m. Celle de la figure 10 est obtenue pour un motif dont les dimensions des cavités sont 800 $\mu$m x 800 $\mu$m.

Les avantages du procédé selon l'invention sont les suivants :

- obtention d'une structure « double air gap » par mise en forme de la couche sacrificielle,
- procédé moins coûteux que ceux de l'art antérieur : un seul masque est utilisé pour réaliser le « double air gap » au lieu de deux ou plus dans l'art connu,
- la mise en forme de la couche sacrificielle est générique, d'autres profils étant possibles et potentiellement intéressants pour d'autres composants.

On va maintenant détailler plus précisément la réalisation de la partie d'un MEMS comprenant une cavité et une poutre dont le déplacement est commandé par une tension d'actionnement appliquée à deux électrodes en regard.

La tension d'actionnement génère une force électrostatique $F_E$ telle que :

$$F_E = \frac{\varepsilon_0 S V^2}{2d_0}$$

avec :

$\varepsilon_0 = $ 8,854.10$^{-12}$ farad.m$^{-1}$
$S = $ surface d'électrode en regard
$V = $ tension d'actionnement
$d_0 = $ entrefer initial

A l' équilibre des forces $F_E + F_{rappel} = 0$
Donc :

$$\frac{\varepsilon_0 S V^2}{2d_0} + ky = 0$$

k étant la rigidité de la capacité variable (partie mobile : poutre) $= \dfrac{192 EI}{L^3}$

E étant le module d'Young (caractéristique du matériau)

l étant l'inertie $= \dfrac{w^3 h}{12}$ (w étant la largeur de la poutre et h son épaisseur)

On peut donc, à partir de toutes ces expressions, déterminer des valeurs pour L, w, h et y permettant de répondre à la tension d'actionnement du cahier des charges.
Remarque : E est fonction du matériau choisi, et h (épaisseur de la structure mobile) dépend en partie du process (épaisseur de couche nécessaire pour assurer la continuité électrique et épaisseur minimale ou maximale possibles par la méthode de dépôt choisie...).
L et w donnent les dimensions en x et y de la cavité :

• L= longueur de la poutre = longueur de la cavité
• w = largeur de la poutre, donc la largeur de la cavité sera égale à w + deux zones de part et d'autre pour la libération (par exemple 50 $\mu$m, soit une largeur de cavité de w + 100 $\mu$m)

y donnera la profondeur de la cavité :

• Pour un commutateur, il faut le contact entre la poutre défléchie et le fond de cavité : profondeur cavité = y ,
• Pour une capacité variable c'est plus complexe à cause du « pull-in » ...

Notons que plusieurs jeux de valeurs L, w, y peuvent répondre au cahier des charges.
Désormais, la profondeur de cavité est connue. Elle sera de l'ordre de quelques centaines de nm à quelques $\mu$m pour une poutre allant de quelques $\mu$m à quelques dizaines ou centaines de $\mu$m de long pour quelques centaines de nm à quelques dizaines de $\mu$m de large.
Il faut utiliser une résine sacrificielle permettant d'obtenir une épaisseur supérieure à cette profondeur. Les résines utilisées en photolithographie sont connues et caractérisées par une épaisseur maximale d'enduction. Ces données sont des données fabriquant, données à l'achat des résines. Le tableau suivant résume quelques caractéristiques des résines disponibles commercialement.

| Résine | Polarité | épaisseur | Uniformité |
|---|---|---|---|
| JSR PFR IX420H 19 cP | R + | $1\mu m<Ep<2\mu m$ | +/-2% |
| JSR PFR IX 50DEL 30 cP | R + | $1\mu m<Ep<2\mu m$ | +/-2% |
| JSR PFR IX 335H 30 cP | R + | $2\mu m<Ep<5\mu m$ | +/-2% |
| Clariant AZ 4562 | R + | $5\mu m<Ep<12\mu m$ | +/-4% |
| Clariant AZ 5740 | R + | $10\mu m<Ep<50\mu m$ | +/-4% |
| Shipley S 1805 | R + | $0.5\mu m<Ep<1\mu m$ | +/-2% |
| Shipley: S 1813 SP15 | R + | $1\mu m<Ep<2\mu m$ | +/-2% |
| Shipley: S1828 | R + | $2\mu m<Ep<5\mu m$ | +/-2% |
| NFR 012 | R + | $1\mu m<Ep<6\mu m$ | +/-2% |
| NFR 015 | R + | $5\mu m<Ep<15\mu m$ | +/-2% |
| Cyclotene: BCB 4022 | R - | $2.5\mu m<Ep<5\mu m$ | 4% |
| Cyclotene: BCB 4024-40 | R - | $3.5\mu m<Ep<7\mu m$ | 4% |
| Cyclotene: BCB 4026-46 | R - | $8\mu m<Ep<14\mu m$ | 4% |
| Cyclotene: BCB 4050 | R - | $14\mu m<Ep<30\mu m$ | 4% |
| Cyclotene: BCB 4024-40 dilué au mésitylène | R - | $1.25\ \mu m$ | +/- $0.26\ \mu m$ |
| Arch: durimide 7505 | R - | $0.5\ \mu m<Ep<3.5\ \mu m$ | 4% |
| Arch: durimide 7510 | R - | $3.5\mu m<Ep<\mu m$ | 4% |
| Arch: durimide 7520 | R - | $8\mu m<Ep<14\mu m$ | 4% |

## DOCUMENTS CITES

[1] « Strength of materials », S. TIMOSHENKO, édité par D. Van Nostrand Co., Inc., Princeton, NJ, 1941.

[2] « Fabrication of high power RF MEMS switches », L. WANG et al., Microelectronic Engineering 83 (2006) 1418-1420.

[3] « Development of a wide tuning range two parallel plate tunable capacitor for integrated wireless communication systems », J. ZOU et al., John Wiley and sons, 2001, pages 322 à 329.

[4] « Development of a wide tuning range MEMS tunable capacitor for wireless communication systems », J. ZOU et al., University of Illinois, Urbana, IL, USA, 0-7803-6438-4/00, IEEE, 2002.

## Revendications

**1.** Procédé de réalisation d'une couche sacrificielle, comprenant les étapes de :

- lithographie d'une résine déposée sur un substrat pour fournir un motif de résine lithographiée sur une zone de substrat, la zone ayant une taille donnée et une forme donnée, le motif occupant un volume donné,
- recuit selon un cycle thermique du motif de résine lithographiée,

le procédé étant **caractérisé en ce qu'**il comprend, en fonction de la résine, la détermination de la taille et de la forme de ladite zone du substrat, et la détermination du volume de la résine déposée sur ladite zone pour que le cycle thermique de recuit fournisse un profil choisi parmi l'un des profils suivants : un profil bombé planarisant et un profil en « double air gap », dans lequel, la couche sacrificielle étant destinée à servir de support de formation d'un élément suspendu, la détermination de la taille et de la forme de ladite zone et la détermination du volume de la résine déposée sur ladite zone sont obtenues par la délimitation d'une gamme de fréquence de résonance pour l'élément suspendu, ce qui définit l'intervalle devant séparer l'élément suspendu de ladite zone de substrat, la résine étant alors choisie pour procurer un motif capable de fournir ledit intervalle.

2. Procédé selon la revendication 1, dans lequel la résine est une résine polymère photosensible.

3. Procédé selon l'une des revendications 1 ou 2, dans lequel ladite zone du substrat est constituée par le fond d'une cavité réalisée dans le substrat.

4. Procédé selon l'une quelconque des revendications 1 à 3, dans lequel, ladite zone du substrat présentant une topologie de surface, les étapes de lithographie et de recuit sont réalisées en plusieurs fois, le procédé comprenant :

   - une première étape de lithographie effectuée à partir d'une première couche de résine fournissant un premier élément de motif au moyen d'un masque,
   - une première étape de recuit du premier élément de motif,
   - une étape d'amincissement du premier élément de motif pour minimiser la topologie de surface de ladite zone reproduite à la surface du premier élément de motif,
   - une deuxième étape de lithographie effectuée à partir d'une deuxième couche de résine déposée sur le substrat, fournissant, au moyen dudit masque, un deuxième élément de motif superposé au premier élément de motif aminci pour constituer ledit motif,
   - une deuxième étape de recuit appliquée au motif obtenu, la première étape de recuit et la deuxième étape de recuit fournissant au motif obtenu un profil bombé planarisant.

5. Procédé selon l'une quelconque des revendications 1 à 3, dans lequel, ladite zone du substrat présentant une topologie de surface, les étapes de lithographie et de recuit sont réalisées en plusieurs fois, le procédé comprenant :

   - une première étape de lithographie effectuée à partir d'une première couche de résine fournissant un premier élément de motif au moyen d'un masque,
   - une première étape de recuit du premier élément de motif,
   - une étape d'amincissement du premier élément de motif pour minimiser la topologie de surface de ladite zone reproduite à la surface du premier élément de motif,
   - une deuxième étape de lithographie effectuée à partir d'une deuxième couche de résine déposée sur le substrat, fournissant, au moyen dudit masque, un deuxième élément de motif superposé au premier élément de motif aminci,
   - une deuxième étape de recuit appliquée à la superposition du premier élément de motif et du deuxième élément de motif, provoquant l'apparition de deux pics sur ladite superposition, constituant un profil en « double air gap »,
   - une troisième étape de lithographie effectuée à partir d'une troisième couche de résine déposée sur le substrat, fournissant, au moyen dudit masque, un troisième élément de motif superposé au premier élément de motif et au deuxième élément de motif aminci,
   - une troisième étape de recuit appliquée à la superposition d'éléments de motif obtenu pour conférer au motif obtenu le profil final en « double air gap ».

```
                          ┌─────────────────────────────┐
                          │ Profil de la couche sacrificielle │
                          └─────────────────────────────┘
```

| Choix de la résine | Géometrie des motifs | Dépôt de la résine | Energie d'insolation | Traitement thermique |
|---|---|---|---|---|
| Formulation de la résine / Propriétes visco-élastiques | La forme des motifs / La taille des motifs | Méthode de dépôt / Epaisseur de la résine | Type de rayonnement / Temps d'insolation | La forme des motifs / La taille des motifs |

# FIG.1

# FIG.2A

# FIG.2B

# FIG.2C

FIG.3A

FIG.3B

FIG.4

FIG.5A

FIG.5B

FIG.6

FIG.7A

FIG.7B

FIG.7C

21

20

## FIG.8A

22

20

## FIG.8B

23  24  22  25

## FIG.8C

26

22

20

## FIG.8D

FIG.8E

FIG.8F

FIG.8G

29

30          30                26

## FIG.8H

29

31

## FIG.8I

FIG.9

FIG.10

**Office européen
des brevets**

**RAPPORT DE RECHERCHE EUROPEENNE**

Numéro de la demande

EP 07 11 6290

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | SOULIMANE ET AL: "Polymeric material sacrificial layer for MEMS fabrication" NANOFUN-POLY INTERNATIONAL CONFERENCE, 29 mai 2006 (2006-05-29), - 31 mai 2006 (2006-05-31) XP002432492 Villeurbanne * le document en entier * ----- | 1-3 | INV. B81B3/00 H01G5/16 |
| A | GALLANT A J ET AL: "Sacrificial layers for widely tunable capacitors - MEMS and microsystems engineering" IEE PROCEEDINGS: SCIENCE, MEASUREMENT AND TECHNOLOGY, IEE, STEVENAGE, HERTS, GB, vol. 151, no. 2, 3 mars 2004 (2004-03-03), pages 104-109, XP006021520 ISSN: 1350-2344 ----- | | |
| A | WO 03/078299 A (ECOLE POLYTECH [CH]; IONESCU MIHAI ADRIAN [CH]; FLUCKIGER PHILIPPE [CH] 25 septembre 2003 (2003-09-25) ----- | | |

| | DOMAINES TECHNIQUES RECHERCHES (IPC) |
|---|---|
| | B81B H01G |

Le présent rapport a été établi pour toutes les revendications

| Lieu de la recherche | Date d'achèvement de la recherche | Examinateur |
|---|---|---|
| Berlin | 17 octobre 2007 | Foussier, Philippe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                  
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 11 6290

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-10-2007

| Document brevet cité au rapport de recherche | Date de publication | Membre(s) de la famille de brevet(s) | Date de publication |
|---|---|---|---|
| WO 03078299 A | 25-09-2003 | AU 2002322966 A1<br>US 2005227428 A1 | 29-09-2003<br>13-10-2005 |

Pour tout renseignement concernant cette annexe : voir Journal Officiel de l'Office européen des brevets, No.12/82

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. TIMOSHENKO.** Strength of materials. D. Van Nostrand Co., Inc, 1941
- **L. WANG et al.** Fabrication of high power RF MEMS switches. *Microelectronic Engineering,* 2006, vol. 83, 1418-1420
- **J. ZOU et al.** Development of a wide tuning range two parallel plate tunable capacitor for integrated wireless communication systems. John Wiley and sons, 2001, 322-329
- **J. ZOU et al.** Development of a wide tuning range MEMS tunable capacitor for wireless communication systems. IEEE, 2002